Europäisches Patentamt

European Patent Office

Office européen des brevets

(11) Publication number: **0 145 301**
**B1**

# EUROPEAN PATENT SPECIFICATION

(45) Date of publication of patent specification: **11.07.90**

(51) Int. Cl.⁵: **H 05 K 13/02, B 21 D 43/12**

(21) Application number: **84307813.0**

(22) Date of filing: **12.11.84**

(54) Belt transporter for electronic components.

(30) Priority: **22.11.83 CA 441648**

(43) Date of publication of application:
**19.06.85 Bulletin 85/25**

(45) Publication of the grant of the patent:
**11.07.90 Bulletin 90/28**

(84) Designated Contracting States:
**AT BE CH DE FR GB IT LI LU NL SE**

(56) References cited:
**EP-A-0 014 940**
**DE-A-2 943 969**
**DE-A-3 103 525**
**DE-C- 493 849**
**GB-A-2 033 795**
**GB-A-2 046 140**
**US-A-1 787 458**
**US-A-3 880 020**

(73) Proprietor: **GPD CANADA INC.**
**PO Box 338**
**Gormley Ontario Canada LOH 1GO (CA)**

(72) Inventor: **Storimans, Franciscus J.A.**
**R. R. No. 4**
**Stouffville Ontario (CA)**

(74) Representative: **Sheader, Brian N. et al**
**ERIC POTTER & CLARKSON 27 South Street**
**Reading Berkshire, RG1 4QU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to machines for forming electronic components as known e.g. from DE-A-2 943 969.

Prior Art

In known machines for forming electronic components, the components, which are initially supported by a tape, are severed from the tape and transferred to a transporting conveyor which extends through a working station. Generally, the transporting conveyor is in the form of a transporter wheel which drives the components continuously through a working station. The components are formed by being driven against plow blades or driven between bending wheels or knives. These known mechanisms have not permitted the use of conventional punch press type machine tools and have therefore been difficult to service and maintain. Furthermore, considerable difficulty has been experienced in attempting to accurately position the components with respect to the forming tools to ensure consistent forming of the leads.

Transistors and the like are frequently mounted on endless tapes with the main body portion disposed laterally from an edge of the tape and the leads secured to an edge of the tape. In this configuration, the leads extend parallel to one another in the plane of the tape. In most instances, it is necessary to laterally offset at least one of the leads in the working station. Considerable difficulty has been experienced in effecting this lateral offset after the components have been severed from the tape.

The machine of the present invention provides a simple and efficient component transporting mechanism for transporting the components through a working station in a manner in which they are securely retained until engaged by the working tool.

It is an object of the present invention to provide a simple and efficient machine for forming the leads of electronic components which can be readily serviced.

It is a further object of the present invention to provide support for electronic components in a longitudinally elongated planner work plane which extends through a work station which is large enough to accommodate more than one work mechanism.

Summary of Invention

According to one aspect of the present invention a machine for forming the leads of electronic components, the electronic components being initially arranged with their leads secured to and projecting laterally from an elongated tape at uniformly spaced intervals along the length thereof, said machine comprising: a frame having a support face extending in a first plane, an endless load transporting belt adapted to drivingly engage a lead supporting tape, belt mounting means on said frame and projecting from said first plane for supporting said load transporting belt with its forward run extending along a longitudinally elongated planner work plane which extends through a work station in which leads of electronic components are formed to the required configuration, a first guide rail disposed opposite and extending longitudinally of said forward run to define a component guideway therebetween which extends through said work station, a second guide rail underlying and supporting said forward run of said load transporting belt, and drive means engaging said load transporting belt to drive it through said work station, at least one lead working mechanism located in said work station for use in forming the leads of said electronic components each lead working mechanism being mounted on said support face and projecting outwardly therefrom to an exposed free end, each lead working mechanism having work tool members releasably mounted at the free end thereof, said tool members being located along and disposed laterally outwardly from the forward run of said load transporting belt so as to be moveable in a work plane which is disposed laterally outwardly from the forward run of said load transporting belt so as to be operable to engage the leads of electronic components which project laterally from the load transporting belt in use.

Preferred Embodiment

The invention will be more clearly understood after reference to the following detailed specification read in conjunction with the drawings wherein:

Figure 1 is a pictorial view of a machine for forming electronic components constructed in accordance with an embodiment of the present invention.

Figure 2 is a side view of the upper portion of the front face of the machine of Figure 1.

Figure 3 is a partially exploded view of a lead forming mechanism of Figure 1.

Figure 4 is a rear view of the machine of Figure 1.

Figure 5 is a sectional view taken along the 5—5 of Figure 2.

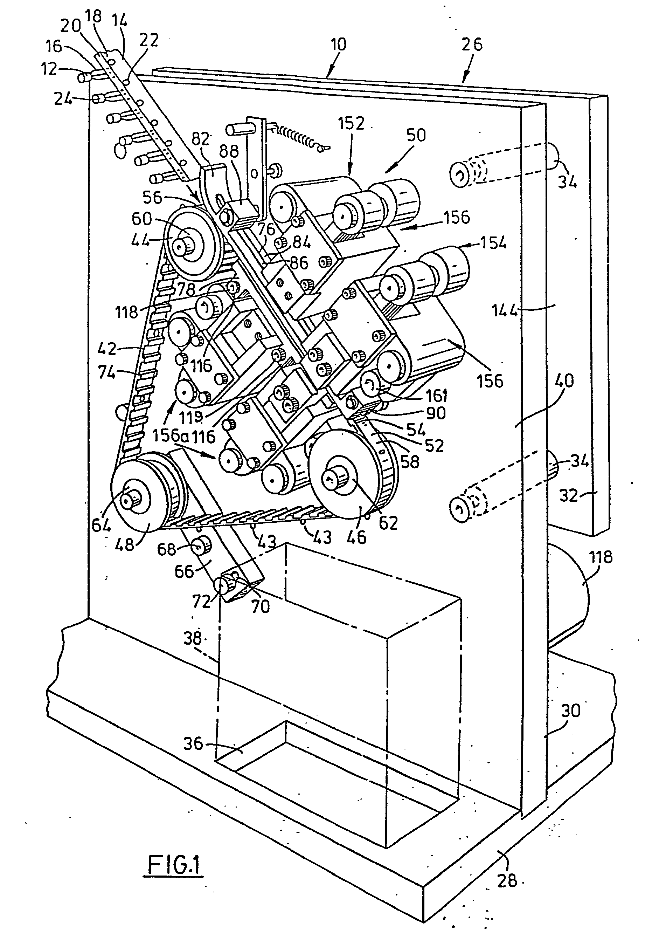

With reference to Figure 1 of the drawings, the reference numeral 10 refers generally to a machine for forming the leads of electronic components constructed in accordance with an embodiment of the present invention.

The electronic components such as transistors 12 are mounted on a tape 14 with the leads 16 trapped between two overlapping layers 18 and 20 of the tape 14. Perforations 22 are formed at uniformly spaced intervals along the length of the tape 14. The main body portions 24 of the transistors 12 are arranged at uniformly spaced intervals along the tape 14 and spaced laterally outwardly from the side edge of the tape 14.

The machine 10 comprises a frame which is generally identified by the reference numeral 26. The frame 26 consists of a base plate 28, an upright front wall 30, a back wall 32 and spacers 34 which serve to support the back wall 32 in a spaced parallel relationship with respect to the front wall 30.

A rectangular shaped aperture 36 is formed in the base plate 28 and serves to support a receptacle 38 in a position to receive formed components.

The front wall 30 has a support face 40 which extends in a vertically oriented first plane. A work station 50 is located on the support face 40. An endless load transporting belt 42 is supported by pulleys 44, 46 and 48 with a forward run portion 52 thereof extending along a longitudinally elongated planner work plane 54 which extends between pulleys 44 and 46. The plane 54 is downwardly and rearwardly inclined from the input end 56 thereof to the output end 58. The pulleys 44 and 48 are mounted for rotation on shafts 60, 62 and 64. The shaft 60 is mounted in the front wall 30 and back wall 32 and projects forwardly from the support face 40. The shaft 62 is mounted in the front wall 30 and projects forwardly from the support face 40. The shaft 64 is mounted on a lever arm 66. The lever arm 66 is pivoted on a pivot pin 68 which projects from the support face 40. An arcuate shaped passage 70 is formed in the lever arm 66 and a mounting screw 72 extends through the passage 70 and is threadedly mounted in a passage formed in the front wall 30. The lever arm 66 can be pivoted about the pivot pin 68 when the mounting screw 72 is released to adjust the tension in the load transporting belt 42 and to facilitate the removal of the load transporting belt 42 as required in use. The pulley 44 is a toothed pulley which is keyed to the shaft 60. The teeth which are formed on the pulley 44 are proportioned to mesh with the teeth 74 formed on the inner face of the load transporting belt 42.

As shown in Figures 1, 2 and 5 of the drawings, a first guide rail 76 and a second guide rail 78 are mounted one on either side of the forward run portion 52 of the load transporting belt 42 and extend longitudinally through the work station 50. The first guide rail 76 and second guide rail 78 are disposed in a face-to-face relationship with respect to one another and define a narrow passage 80 therebetween.

The first guide rail 76 has a front end portion 82 which is outwardly curved to facilitate the entry of the tape 14 into the input end 56. The first guide rail 76 also includes a longitudinally elongated main body portion 84 along the length of which a narrow slot 86 extends. Posts 88 and 90 project upwardly from the main body portion 84 adjacent opposite ends thereof. The post 88 is pivotally connected to a lever arm 92 and the post 90 is pivotally connected to a lever arm 94 by means of pivot pins 96 and 98 respectively. The lever arms 92 and 94 are pivotally mounted on the front wall 30 by means of pivot pins 100 and 102 respectively. The lever arm 92 has an extension 104 which projects from the pivot pin 100. The extension 104 has a pin 106 mounted adjacent its outer end. The inner end of the pin 106 is connected by means of a spring 108 to a pin 110 which is mounted on the front wall 30.

In use, the lever arms 92 and 94 function as a parallogram linkage which serves to maintain the first guide rail 76 parallel to the second guide rail 78 and all positions of the first guide rail 76. Movement of the first guide rail 76 away from the second guide rail 78 can be effected by manually engaging the pin 106 and rotating the lever arm 92 in a counterclockwise direction about the pivot pin 100. By releasing the pin 106, the spring 108 will serve to rotate the lever arm 104 in a clockwise direction thereby moving the first guide rail 76 toward the second guide rail 78.

The second guide rail 78 comprises a longitudinally elongated main body portion 112. A shallow U-shaped channel 114 is formed in the upper face of the second guide rail 112 and extends longitudinally thereof. The channel 112 has a width which is adapted to receive the forward run 52 of the load transporting belt 42 in a close fitting sliding relationship. Support posts 116 depend from the main body portion 112 and mounting pins 119 serve to secure the posts 116 with respect to the front wall 30. Spacers 120 serve to space the guide rail 76 laterally outwardly from the support face 40 of the front wall 30.

The load transporting belt 42 is formed with a plurality of pins 43 projecting upwardly from the outer face thereof and uniformly spaced intervals along the length thereof. The pins 43 are proportioned and aligned to pass longitudinally through the slot 86 formed in the first guide rail 76. The pins 43 are proportioned and spaced so as to project through the perforations 22 of the tape 14 so as to provide a positive drive. A positive drive of the load transporting belt 42 is ensured by the provision of the teeth 74 which are formed on the pulley 44.

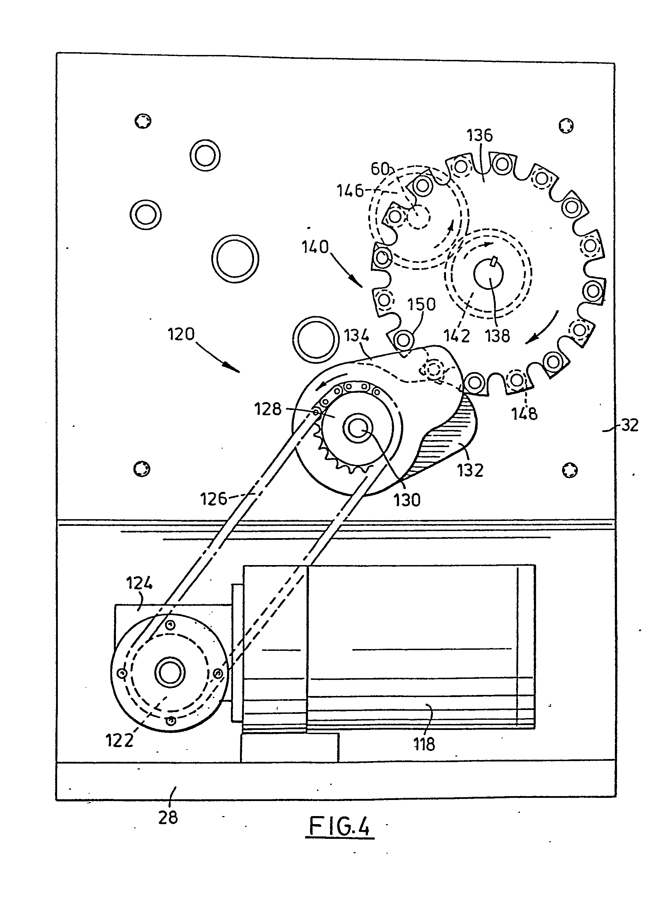

The drive mechanism which provides an intermittent drive for the load transporting belt is generally identified by the reference numeral 120 in Figure 4 to which reference is now made. The drive mechanism includes a motor 118 which is mounted on the base plate 28. The motor 118 drives a sprocket 122 through a reduction gear 124. A chain 126 connects the sprocket 122 to a further sprocket 128. The sprocket 128 is mounted for rotation on a shaft 130 which is supported by the back wall 32. The sprocket 128 is drivingly connected to cams 132 and 134. The cams 132 and 134 are the cam members of a Geneva gear mechanism generally identified by the reference numeral 140 which serves to impart intermittent movement to the load transporting belt 42. The mechanism 140 includes a gear wheel 136 which is keyed to the shaft 138 which is mounted for rotation in the front wall 30 and back wall 32. A gear wheel 142 is keyed to the shaft 138 and is located in the gap 144 which is formed between the front wall 30 and back wall 32. A gear wheel 146 is mounted in the gap 144 and is keyed to the shaft 60. As previously described, the shaft is the shaft on which the pulley 44 is mounted.

In operation, when the drive motor 118 is

activated, it rotatably drives the sprocket 122 which in turn drives a sprocket 128. By rotatably driving the sprocket 128, the cams 132 and 134 successively engage the rollers 148 and 150 of the gear wheel 126 thereby effecting intermittent clockwise rotation of the gear 136 which is transmitted through gears 142 and 146 to the pulley 44.

An important feature of the machine of the present invention is the fact that the forward run portion 52 of the load transporting belt 42 is longitudinally elongated to an extent sufficient to permit more than one lead forming mechanism to be located along the length thereof. A further important feature is that the return length of the load transporting belt 42 is spaced a sufficient distance from the forward run to permit a portion of each lead forming mechanism to be located inwardly of the path of the load transporting belt. These features are achieved by arranging the pulleys 44, 46 and 48 so as to support the load transporting belt 42 in a generally triangular configuration. In a preferred embodiment, the axis of the sprockets 44, 46 and 48 are spaced from one another a distance of about 13 cm to provide a forward run of about 13 cm.

Within the work station the lead forming mechanisms 152 and 154 are located in series along the forward run 52 of the load transporting belt 42. The first lead forming mechanism 152 comprises two lead forming assemblies 156, 156a which are disposed in laterally spaced opposed relation one to the other identical in construction with the exception of being a mirror image as shown in Figure 1. Each assembly 156 has a main housing 158 which is secured with respect to the base plate 28 by means of a dowl pin 160 and a mounting screw 162 (Fig. 1). The housing 158 is formed with a U-shaped channel 163 within which a slide plate 164 is slidably mounted in a close fitting sliding relationship. The slide plate 164 is formed with a slot 168 which opens from one end thereof. The drive mechanism which drives the slide plate 164 includes an arm 166 which has one end located in the slot 168 of the slide plate 164. A pivot pin 170 is located in the passages 172, 174 and 176 of the slide 164 and arm 166 respectively. A face plate 178 is secured by means of a plurality of mounting screws 180 to the main housing 158 in a position overlying the top plate 160 enclosing a portion of the outer end of the channel 162. A removable forming tool 182 is secured by means of mounting screws 184 to the outer end of the slide member 164.

The arm 166 has a pin 186 rotatably mounted at its other end. The pin 186 is eccentrically mounted on a shaft 188. The shaft 188 has a portion of reduced diameter 190 which is mounted in a bearing 192 supported by the front wall 30. A gear wheel 194 is mounted on the shaft 190 and serves to rotatably drive the shaft 190.

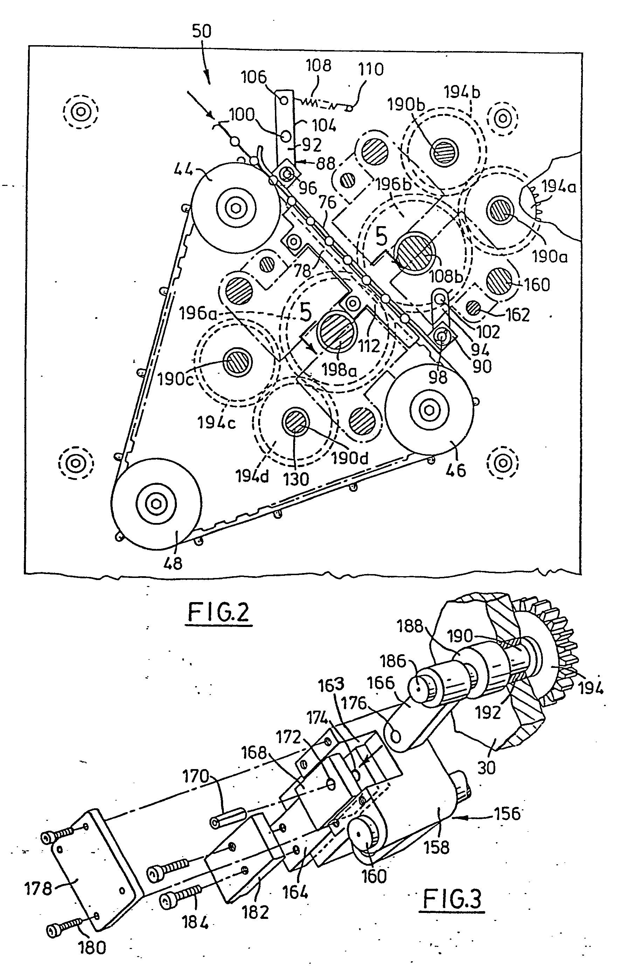

Each assembly 156 and 156a has a gear wheel 194 and a shaft 190. The gear wheels 194 are distinguished in Figure 2 of the drawings by being identified by the reference numerals 194a, 194b, 194c and 194d. Similarly, shafts 190 are distinguished by being designated 190a, 190b, 190c and 190d.

It will be noted that the shaft 190d is an extension of the shaft 130 (Fig. 4) which is driven by the sprocket 128 in response to operation of the motor 118. The gear wheel 190d is meshed with the gear wheel 190c to rotatably drive the gear wheel 190c. Similarly, the gear wheel 190d is meshed with a gear wheel 196a which is mounted for rotation on shaft 198a which is mounted in the front wall 30 and back wall 32. The gear wheel 196a is meshed with a gear wheel 196b which is mounted on a shaft 198b. The shaft 198b is mounted in the front wall 30 and back 32. The gear wheel 196b is meshed with the gear wheel 194a which is in turn meshed with the gear wheel 194b. Thus, rotation of the gear wheel 194d causes simultaneously rotation of the gear wheels 194a, 194b and 194c which effects reciprocating movement of the tool members 182 toward and away from the work path 54 as required in use.

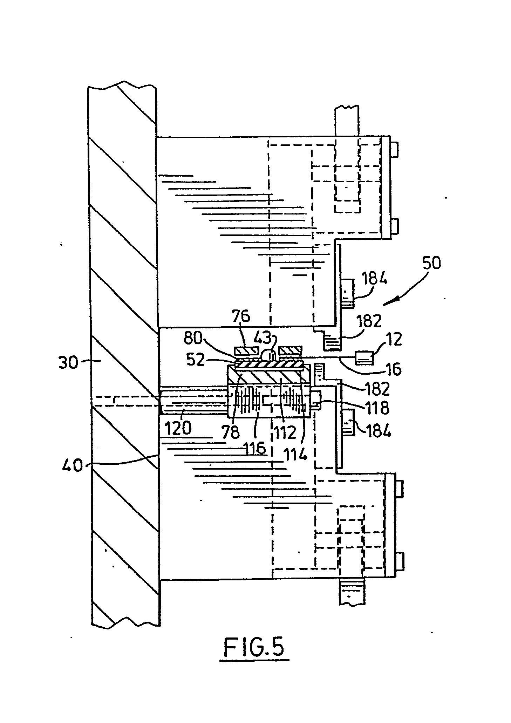

As shown in Figure 5 of the drawings, the work tools 182 are arranged to operate in a plane which is laterally displaced from the work path so as to be arranged to engage the leads 16 of the components 12. It will be understood that the tools 182 may be adapted to perform any required bending operation or cutting operation on the leads 16. It should also be apparent that the tools 182 may be very easily removed for servicing by releasing the mounting screws 184.

In the preferred embodiment, the lead forming mechanism 152 has removable tools 182 which are adapted to bend the leads to the required configuration and the mechanism 154 has removable tools 182 in the form of cutter blades used for severing the leads at the required length to separate the component from the tape 14.

In use, the first guide rail 76 is raised and a tape 14 bearing a plurality of components 12 is fed through the input end 56 into the guide way 80 until one of the perforations 22 in the tape 14 is aligned with one of the pins 43 of the load transporting belt 42. The first guide rail 76 is then lowered to cause the pin 43 to penetrate the perforation 24 thereby securing the tape 14 for movement with the load transporting belt 42. After the motor 118 is activated the Geneva gear 140 which is driven by the motor 118 imparts an intermittent forward movement to the load transporting belt 42 which serves to advance the tape 14 in a series of intermittent steps through the work station 50 so as to initially position each component 24 in an operable position with respect to the lead forming mechanism 152 and subsequently an inoperable position with respect to the lead forming mechanism 154 whereby the leads of successive components are initially formed to the required configuration and thereafter severed at the required length. The thus formed lead drop into the receptacle 38 and the tape is discharged into a suitable receptacle (not shown) in which it is accumulated prior to disposal.

From the foregoing it will be seen that the machine of the present invention serves to permit conventional press type forming tools to be used in the forming of the leads of electronic components.

These and other advantages of the machine of the present invention will be apparent to those skilled in the art.

## Claims

1. A machine for forming the leads of electronic components, the electronic components (12) being initially arranged with their leads secured to and projecting laterally from an elongated tape (14) at uniformly spaced intervals along the length thereof, said machine comprising:

a) a frame (26) having a support face (40) extending in a first plane,

b) an endless load transporting belt (42) adapted to drivingly engage the lead supporting tape,

c) belt mounting means (4, 4, 4) on said frame and projecting from said first plane for supporting said load transporting belt with its forward run extending along a longitudinally elongated planner work plane (54) which extends through a work station (50) in which leads of electronic components are formed to the required configuration,

d) a first guide rail (76) disposed opposite and extending longitudinally of said forward run to define a component guideway therebetween which extends through said work station,

e) a second guide rail (78) underlying and supporting said forward run of said load transporting belt, and

f) drive means (120) engaging said load transporting belt to drive it through said work station,

g) at least one lead working mechanism (152) located in said work station for use in forming the leads of said electronic components each lead working mechanism being mounted on said support face (40) and projecting outwardly therefrom to an exposed free end, each lead working mechanism having work tool members releasably mounted at the free end thereof, said tool members being located along and disposed laterally outwardly from the forward run of said load transporting belt so as to be moveable in a work plane which is disposed laterally outwardly from the forward run of said load transporting belt so as to be operable to engage the leads of electronic components which project laterally from the load transporting belt in use.

2. A machine as claimed in claim 1 wherein the forward run is downwardly and forwardly inclined so as to permit the lowermost component to fall freely from the elongated tape after it is formed and severed from the elongated tape.

3. A machine as claimed in claim 1 wherein each lead working mechanism comprises first and second complementary forming assemblies (182) located one on either side of said work plane, said assemblies having a work tool mounted for movement toward and away from said work plane between an open position permitting free movement of said load transporting belt through said working station and a closed position in which they operate to work the components, a drive motor (118), a first intermittent power transmission means (140) communicating between the drive motor and said load transporting belt (42), and second intermittent power transmission means communicating between the drive motor and said first and second complementary forming assemblies, said first and second intermittent power transmission means being synchronized such that said load transporting belt is held stationary when said first and second complementary forming assemblies are activated to work on a component, and said first and second complementary forming assemblies are held stationary when said load transporting belt is driven.

## Patentansprüche

1. Maschine, um die Leiter von elektronischen Komponenten zu formen, wobei die elektronischen Komponenten (12) anfänglich so angeordnet sind, daß ihre Leiter an einem länglichen Band (14) befestigt sind und von diesem entlang seiner gesamten Länge seitlich in gleichmäßig voneinander entfernten Intervallen vorstehen, wobei diese Maschine umfaßt:

a) einen Rahmen (26), der eine Haltefläche (40) aufweist, die sich in einer ersten Ebene erstreckt,

b) ein endloses, das Gut transportierendes Band (42), welches dazu ausgelegt ist, antreibend das die Leiter tragende Band zu beaufschlagen,

c) das Band haltende Mittel (4, 4, 4) an dem Rahmen und sich von der ersten Ebene erstreckend, um das das Gut transportierende Band zu tragen, dessen Vordertrum sich entlang einer länglichen und längs ausgerichteten Planwerkebene (54) erstreckt, die sich durch eine Arbeitsgruppe (50) erstreckt, in der Leiter von elektronischen Komponenten zu der erforderten Anordnung geformt werden,

d) eine erste Führungsschiene (76), die gegenüber und sich längs des Vordertrums erstreckend angeordnet ist, um eine Komponentenführung dazwischen zu definieren, die sich durch die Arbeitsgruppe erstreckt,

e) eine zweite Führungsschiene (78), die unter dem Vordertrum des das Gut transportierenden Bandes und dieses stützend angeordnet ist und

f) Antriebsmittel (120), die das das Gut transportierende Band beaufschlagen, um es durch die Arbeitsgruppe anzutreiben,

g) zumindest einen leiterbearbeitenden Mechanismus (152), der in der Arbeitsgruppe angeordnet ist, für die Verwendung in der Formung der Leiter der elektronischen Komponenten, wobei jeder leiterbearbeitende Mechanismus an der Haltefläche (40) befestigt ist und sich von dieser nach außen zu einem freien Ende erstreckt, wobei jeder leiterbearbeitende Mechanismus Arbeitswerkzeugelemente umfaßt, die lösbar an seinem freien Ende befestigt sind, wobei diese Werkzeugelemente entlang und seitlich außen von dem Vordertrum des das Gut transportierenden Bandes angeordnet sind, so daß sie in einer Arbeitsebene bewegbar sind, die seitlich außen von dem Vordertrum des das Gut transportierenden Bandes angeordnet ist, um so betätigbar zu sein, um die Leiter der elektronischen Komponenten zu beaufschlagen, welche seitlich von dem das Gut transportierenden Band im Betrieb vorstehen.

2. Maschine nach Anspruch 1, wobei das Vordertrum nach unten und vorne geneigt ist, um der untersten Komponente zu erlauben, frei von dem länglichen Band zu fallen, nachdem sie geformt und von dem länglichen Band getrennt worden ist.

3. Maschine nach Anspruch 1, wobei jeder leiterbearbeitende Mechanismus erste und zweite zusammenwirkende Formbaugruppen (182) umfaßt, die jeweils eine an jeder Seite der Werkebene angeordnet sind, wobei die Baugruppen ein Arbeitswerkzeug beweglich befestigt haben für eine Bewegung zu und weg von der Werkebene zwischen einer geöffneten Stellung, die eine freie Bewegung des das Gut transportierenden Bandes durch die Arbeitsgruppe erlaubt und einer geschlossenen Stellung, in welcher sie wirken, um die Komponenten zu bearbeiten, einen Antriebsmotor (118), eine erste intermittierende Kraftübertragungseinrichtung (140), die dem Antriebsmotor und dem das Gut transportierenden Band (42) zwischengeschaltet ist, und zweite intermittierende Kraftübertragungsmittel, die dem Antriebsmotor und den ersten und zweiten zusammenwirkenden Formbaugruppen zwischengeschaltet sind, wobei die ersten und zweiten intermittierenden Kraftübertragungsmittel so synchronisiert sind, daß das das Gut transportierende Band stillstehend gehalten wird, wenn die erste und zweite zusammenwirkenden Formbaugruppen betätigt werden, um eine Komponente zu bearbeiten, und die erste und zweite zusammenwirkende Formbaugruppen werden im Stillstand gehalten, wenn das das Gut transportierende Band angetrieben wird.

**Revendications**

1. Une machine pour former les plots de contact de composantes électroniques, les composantes électroniques (12) étant initialement disposées à intervalles réguliers le long d'un ruban (14), les plots de contact des composantes électroniques étant retenus au ruban et faisant saillie latéralement de ce dernier, ladite machine comprenant:

a) un bâti (26) ayant une surface de support (40) située dans un premier plan;

b) une courroie transporteuse sans fin (42) destinée à entraîner le ruban de support des plots de contact;

c) un dispositif de support de courroie (44, 46, 48) sur ledit bâti faisant saillie dudit premier plan pour supporter ladite courroie transporteuse sans fin de manière à ce que son tronçon d'amenée de composantes électroniques soit situé le long d'un plan de travail (54) passant par une station de mise-en-forme (50) dans laquelle les plots de contact de composantes électroniques sont façonnées en forme requise;

d) un premier rail de guidage (76) vis-à-vis ledit tronçon d'amenée et se prolongeant le long de ce dernier, ledit premier rail de guidage et ledit tronçon d'amenée formant guide à composantes électroniques passant à travers ladite station de mise-en-forme;

e) un second rail de guidage (78) sous ledit tronçon d'amenée et supportant ce dernier;

f) un moyen d'entraînement (120) couplé à ladite courroie transporteuse sans fin pour l'entraîner à travers ladite station de mise-en-forme; et

g) au moins un organe de façonnement (152) dans ladite station de mise-en-forme pour façonner les plots de contact desdites composantes électroniques, chaque organe de façonnement étant monté à ladite surface de support (40) et faisant saillie de cette dernière, chaque organe de fonctionnement présentant une extrémité libre pourvue de pièces-outils amovibles, lesdites pièces-outils étant disposées le long et étant latéralement décalées vers l'extérieur du tronçon d'amenée de ladite courroie transporteuse sans fin pour se mouvoir dans un plan de travail qui est décalé latéralement vers l'extérieur du tronçon d'amenée de ladite courroie transporteuse sans fin afin de pouvoir engager les plots de contacts de composantes électroniques faisant latéralement saillie de la courroie transporteuse sans fin en opération.

2. Une machine telle que revendiquée dans la revendication 1, caractérisée en ce que ledit tronçon d'amenée s'incline vers le bas en avançant pour permettre la chute libre de la composante au plus bas après sa misen-forme et détachement dudit ruban.

3. Une machine telle que revendiquée dans la revendication 1, caractérisée en ce que chaque organe de façonnement comporte un premier et un second assemblages (182) complémentaires de mise-en-forme disposés de part et d'autre dudit plan de travail, lesdits assemblages ayant un outil pouvant être animé d'un mouvement de va-et-vient par rapport audit plan de travail entre une position dite ouverte permettant le libre mouvement de ladite courroie transporteuse sans fin à travers ladite station de mise-en-forme et une position dite fermée dans laquelle ils sont opérés pour travailler les composantes, un moteur (118), un premier moyen de transmission de puissance intermittent (140) couplé audit moteur et à ladite courroie transporteuse sans fin (42), et un second moyen de transmission de puissance intermittent couplé audit moteur et auxdits premier et second assemblages complémentaires, lesdits premier et second moyens de transmission de puissance intermittent étant synchronisés de façon à ce que ladite courroie transporteuse sans fin demeure à l'arrêt lorsque lesdits premier et second assemblages complémentaires sont opérés pour travailler une composante, et lesdits premier et second assemblages complémentaires sont maintenus à l'arrêt lorsque ladite courroie transporteuse sans fin est entraînée.

FIG.1

1

FIG.2

FIG.3

FIG.4

FIG.5

4